# EUROPEAN PATENT APPLICATION

(11) **EP 4 210 093 A1**
(43) Date of publication of application: **12.07.2023**
(21) Application number: 20954676.1
(22) Date of filing: 27.09.2020
(51) Int. Cl.: H01L 21/768, H01L 23/48

(54) **PREPARATION METHOD FOR THROUGH SILICON VIA STRUCTURE, AND THROUGH SILICON VIA STRUCTURE**

(71) Applicant: Huawei Technologies Co., Ltd., Shenzhen, Guangdong 518129 (CN)
(72) Inventor: LI, Heng, Shenzhen, Guangdong 518129 (CN); ZHANG, Xiaodong, Shenzhen, Guangdong 518129 (CN); HU, Tianqi, Shenzhen, Guangdong 518129 (CN); QI, Xiaoyun, Shenzhen, Guangdong 518129 (CN)
(74) Representative: Gill Jennings & Every LLP
(86) International application number: PCT/CN2020/118157
(87) International publication number: WO 2022/061825

(57) **Abstract**

This application provides a through silicon via structure fabrication method and a through silicon via structure. The fabrication method includes: providing a wafer, where the wafer includes a substrate layer, a dielectric layer, and a metal layer; forming, on a second side of the substrate layer, a via that penetrates through the substrate layer, where the via stops at the metal layer; forming a concave hole on the second side of the substrate layer; depositing metal on a surface of the second side of the substrate layer and in the via and the concave hole; and polishing the metal to remove metal in a region that is on the surface of the second side of the substrate layer and that is other than the via and the concave hole. In this application, disposing the concave hole can add metal to a place at which there is no via at the substrate layer. This helps evenly distribute metal as much as possible in a polishing process, thereby improving consistency and reliability of a polishing technology. In addition, because a TSV corresponding to the via in this application may not be a TSV array, a TSV pattern can be flexibly designed depending on a product requirement, to increase a process window.

## Description

### TECHNICAL FIELD

This application relates to the field of chip packaging technologies, and more specifically, to a through silicon via structure fabrication method and a through silicon via structure.

### BACKGROUND

In recent years, as electronic devices develop toward miniaturization and portability, chip packaging technologies gradually develop toward a mature three-dimensional (3 dimensional, 3D) stacked manner. A chip package area can be minimized in a stacked manner, to reduce material construction (build of material, BOM) costs. A stacked packaging technology can be applied to micro-system integration, and is a packaging fabrication technology developed after a system-on-a-chip (system-on-a-chip, SoC) and a multi-chip module (multi-chip module, MCM).

In a conventional two-dimensional (2 dimensional, 2D) chip, all modules in the chip are placed at a plane layer. In contrast, a 3D chip allows multi-layer stacking of dies (dies or chips (chip)), and may implement a signal connection between a plurality of dies in a vertical direction by using through silicon vias (through silicon via, TSV). Therefore, a TSV technology is crucial to a 3D chip stacking technology. With continuous progress of the TSV technology, a stacking density of a chip in a 3D direction increases, and overall dimensions of the chip decrease. This greatly improves a speed of the chip and reduces power consumption of the chip.

Because the TSV technology is relatively complex, there are many constraints on TSV design. For example, only a verified TSV array (array) with an invariable pitch can be used. In view of this, a flexible TSV structure fabrication method is urgently needed.

### SUMMARY

This application provides a through silicon via structure fabrication method and a through silicon via structure, to flexibly fabricate the through silicon via structure.

According to a first aspect, a through silicon via structure fabrication method is provided, including the following steps: providing a wafer, where the wafer includes a substrate layer, a dielectric layer, and a metal layer, the metal layer is wrapped in the dielectric layer, and the dielectric layer and the metal layer are located on a first side of the substrate layer; forming, on a second side of the substrate layer, a via that penetrates through the substrate layer, where the via stops at the metal layer; forming a concave hole on the second side of the substrate layer; depositing metal on a surface of the second side of the substrate layer and in the via and the concave hole; and polishing the metal to remove metal in a region that is on the surface of the second side of the substrate layer and that is other than the via and the concave hole.

In this embodiment of this application, when through silicon vias are formed on the wafer, the concave hole and the via that is used to form a through silicon via may be formed on one side of the substrate layer, and on the side of the substrate layer, the metal is deposited on the surface of the substrate layer and in the via and the concave hole. In this way, when polishing is performed on the metal on the surface of the substrate layer, disposing the concave hole can add metal to a place at which there is no via at the substrate layer. This helps evenly distribute metal as much as possible in a polishing process, thereby improving consistency and reliability of a polishing technology.

For example, in this embodiment of this application, the TSV corresponding to the via may not be a TSV array or may not be a TSV array verified by a vendor (vendor). By adding the concave hole at the substrate layer, in a subsequent polishing technology, the TSVs of the wafer can be equivalent to a TSV array or the TSV array verified by the vendor. Therefore, in comparison with a TSV fabrication solution in which no concave hole is formed, metal can be distributed more evenly in the subsequent polishing technology in this embodiment of this application. This reduces polishing complexity. Further, because the TSV corresponding to the via in this application may not be a TSV array or may not be the TSV array verified by the vendor, a TSV pattern can be flexibly designed depending on a product requirement in this application, to increase a process window.

In an example, polishing the metal may start from polishing the metal deposited on the second side of the substrate layer. Optionally, when there is no remaining metal on the surface of the second side of the substrate layer after polishing, the second side of the substrate layer can still continue to be polished. This is not limited in this application.

With reference to the first aspect, in some implementations of the first aspect, there is remaining metal in the concave hole after the polishing. In this way, there can always be remaining metal in the concave hole in the polishing process. This helps evenly distribute metal in the polishing process.

In some optional embodiments, there is remaining metal in the concave hole in the polishing process, and after the polishing, there may be no remaining metal in the concave hole or there is no concave hole on the surface of the substrate layer. This is not limited in this application.

In some possible implementations, to make remaining metal exist in the concave hole after the polishing or in the polishing process, an appropriate depth of the concave hole may be set. The depth of the concave hole cannot be excessively shallow, to ensure that there is always metal in the concave hole in the polishing process or after the polishing. In addition, the depth of the concave hole cannot be excessively deep, to avoid affecting component performance or increasing technology difficulty.

In an example, the depth of the concave hole may range from 1 micrometer (µm) to 30 micrometers. This is not limited in this application.

In a manner of stopping the via at the metal layer, etching time (or etching time and an etching rate) may be controlled, so that the metal layer is exposed from inside the via when an etching process for the via ends.

In another manner of stopping the via at the metal layer, the wafer may include an etching stop layer, and the etching stop layer is located between the metal layer and the substrate layer, for example, may be connected to a surface of the metal layer. In this case, etching time (or etching time and an etching rate) is controlled, so that after a first time period expires, the via stops at the etching stop layer. Then, the etching stop layer may be etched. For example, etching time (or etching time and an etching rate) may be controlled, so that after a second time period expires, the via stops at the metal layer.

With reference to the first aspect, in some implementations of the first aspect, there is at least one via, there is at least one concave hole, each via forms a first pattern on the surface of the second side of the substrate layer, each concave hole forms a second pattern on the surface of the second side of the substrate layer, and at least one first pattern and at least one second pattern on the surface of the second side have a same adjacent-pattern distance in a width direction, and/or a same adjacent-pattern distance in a length direction.

In some optional embodiments, a TSV corresponding to the at least one first pattern (that is, the TSV corresponding to the via) and a dummy pad corresponding to the at least one second pattern (that is, a dummy pad corresponding to the concave hole) may be jointly equivalent to a TSV array constructed in a TSV structure fabrication process. In other words, the TSV corresponding to the at least one first pattern and the dummy pad corresponding to the at least one second pattern may be jointly referred to as an equivalent TSV array of the wafer.

Therefore, for the at least one first pattern formed by the via and the at least one second pattern formed by the concave hole on the surface of the second side of the substrate layer, the distance between any two adjacent patterns in the width direction is equal to the distance between any other two adjacent patterns in the width direction, and/or the distance between any two adjacent patterns in the length direction is equal to the distance between any other two adjacent patterns in the length direction, so that the via and the concave hole can be evenly distributed on the surface of the substrate layer. This helps the wafer have the equivalent TSV array, and helps evenly distribute metal in the subsequent polishing process.

Because concave holes are disposed between vias or around vias, the any two adjacent patterns may include a pattern corresponding to a concave hole and a pattern of a via adjacent to the concave hole, or a pattern corresponding to a concave hole and a pattern of another concave hole adjacent to the concave hole, or a pattern corresponding to a via and a pattern of another via adjacent to the via.

With reference to the first aspect, in some implementations of the first aspect, when there is one via, there are eight concave holes, and the eight concave holes are evenly distributed around the via. In this way, in patterns corresponding to the eight concave holes and a pattern corresponding to the one via, a distance between any two adjacent patterns in the length direction is equal to a distance between any other two adjacent patterns in the length direction, and a distance between any two adjacent patterns in the width direction is equal to a distance between any other two adjacent patterns in the width direction. In other words, the wafer has a 3×3 equivalent TSV array.

In some optional embodiments, concave holes of another quantity may be alternatively added around the one via. In patterns formed by these concave holes on the surface of the substrate layer and a pattern formed by the via, a distance between any two adjacent patterns in the length direction is equal to a distance between any other two adjacent patterns in the length direction, and a distance between any two adjacent patterns in the width direction is equal to a distance between any other two adjacent patterns in the width direction. For example, there may be 15 added concave holes, so that the equivalent TSV array of the wafer is a 4×4 TSV array. For another example, there may be 11 added concave holes, so that the wafer has a 4×3 equivalent TSV array.

With reference to the first aspect, in some implementations of the first aspect, there are a plurality of vias, and the plurality of vias include a first group of vias and a second group of vias; on the surface of the second side of the substrate layer, a first distance exists between any two adjacent vias in a first direction in the first group of vias, and a second distance exists between any two adjacent vias in the first direction in the second group of vias; and if the first distance is an integer multiple of the second distance, the concave hole is located between two adjacent vias in the first direction in the first group of vias, where the first direction is the length direction or the width direction.

Therefore, in a pattern corresponding to the concave hole and patterns corresponding to the vias, the pattern corresponding to the concave hole may be located between two adjacent patterns in the first direction in first group of patterns, so that after the concave hole is added, a distance between two adjacent patterns in the first direction in the pattern corresponding to the concave hole of the first group of patterns is also the second distance. In this way, for patterns formed on a lower surface of the entire substrate layer, a distance between any two adjacent patterns in the first direction is equal to a distance between any other two adjacent patterns in the first direction, namely, the second distance. Therefore, in this embodiment of this application, the vias and the concave hole can be evenly distributed on the surface of the substrate layer. This helps the wafer have the equivalent TSV array, and helps evenly distribute metal in the subsequent polishing process.

In some optional embodiments, on the surface of the substrate layer, when a first distance between any two adjacent vias in the first direction in the first group of vias is greater than a second distance between any two adjacent vias in the first direction in the second group of vias, but the first distance is not an integer multiple of the second distance, at least one concave hole can still be disposed between the first group of vias, so that the patterns formed by the concave hole and the vias on the surface of the substrate layer look as regular or even as possible. In this way, the vias and the concave hole can be evenly distributed on the surface of the substrate layer, thereby helping evenly distribute metal in the subsequent polishing process.

In some optional embodiments, when patterns corresponding to vias are irregular (that is, TSVs corresponding to the vias are not a TSV array), for example, when a distance between adjacent vias in the width direction or the length direction is different from a distance between other adjacent vias in the width direction or the length direction, the concave hole may be added between the vias, so that the patterns formed by the concave hole and the vias on the surface of the substrate layer look as regular or even as possible. In this way, the vias and the concave hole can be evenly distributed on the surface of the substrate layer, thereby helping evenly distribute metal in the subsequent polishing process.

In some optional embodiments, when TSVs corresponding to vias are a TSV array, the concave hole can still be added between the vias. For example, when a TSV array corresponding to the vias is not the TSV array verified by the vendor, the concave hole may be added, so that an equivalent TSV array corresponding to the patterns formed by the concave hole and the vias is the TSV array verified by the vendor. For another example, when a TSV array corresponding to the vias is a TSV array with a large pitch, because the vias are sparse, metal is not evenly distributed during subsequent polishing of the metal. In this case, the concave hole is added, so that an equivalent TSV array pitch of the wafer is small. This can help distribute metal more evenly during subsequent polishing.

With reference to the first aspect, in some implementations of the first aspect, the concave hole on the surface of the second side of the substrate layer (that is, a top view of the concave hole) is in a circular, rectangular, or rhombus shape.

In some embodiments, on the surface of the second side of the substrate layer, shapes of the concave hole and the via (that is, a top view of the via) may be the same as or similar to each other, for example, both are circles with a same diameter or similar diameters. This is not limited in this application.

Alternatively, in some other embodiments, on the surface of the second side of the substrate layer, the pattern formed by the concave hole may have a different shape or different dimensions from the pattern formed by the via. For example, the pattern formed by the via is a circle, and the pattern formed by the concave hole is a rhombus, a rectangle, or the like. This is not limited in this application.

With reference to the first aspect, in some implementations of the first aspect, the depositing metal on a surface of the second side of the substrate layer and in the via and the concave hole may include: sequentially forming a liner (liner) layer, a barrier layer, and a seed layer on the surface of the second side of the substrate layer and in the via and the concave hole; and depositing the metal on the seed layer by using an electroplating process.

The liner layer can improve flatness and a stress buffer of an etching surface, and also has a blocking function. The barrier layer may be configured to prevent metal from spreading, for example, prevent metal from spreading to Si or SiO₂, to improve component performance. The seed layer is configured to conduct electricity, to generate a metal film layer in an electroplating manner.

In some optional embodiments, polishing of the metal may be: keeping polishing until polishing performed at the liner layer ends, or keeping polishing until polishing performed at the substrate layer ends, or continuing polishing when polishing performed at the substrate layer ends and there is still remaining metal in the concave hole after the polishing, or keeping polishing until there is no remaining metal in the concave hole. This is not limited in this application.

With reference to the first aspect, in some implementations of the first aspect, the barrier layer includes Ta or TaN.

With reference to the first aspect, in some implementations of the first aspect, the seed layer includes Cu.

With reference to the first aspect, in some implementations of the first aspect, the metal film layer includes Cu.

According to a second aspect, a through silicon via structure is provided, including: a substrate layer, a dielectric layer, a metal layer, a via, and a concave hole, where the metal layer is wrapped in the dielectric layer, and the dielectric layer and the metal layer are located on a first side of the substrate layer; the via penetrates through the substrate layer from a second side of the substrate layer, and stops at the metal layer; the concave hole is formed on the second side of the substrate layer; and metal is deposited in the via and the concave hole.

With reference to the second aspect, in some implementations of the second aspect, there is at least one via, there is at least one concave hole, each via forms a first pattern on a surface of the second side of the substrate layer, each concave hole forms a second pattern on the surface of the second side of the substrate layer, and at least one first pattern and at least one second pattern on the surface of the second side have a same adjacent-pattern distance in a width direction, and/or a same adjacent-pattern distance in a length direction.

With reference to the second aspect, in some implementations of the second aspect, when there is one via, there are eight concave holes, and the eight concave holes are evenly distributed around the via.

With reference to the second aspect, in some implementations of the second aspect, there are a plurality of vias, and the plurality of vias include a first group of vias and a second group of vias; on the surface of the second side of the substrate layer, a first distance exists between any two adjacent vias in a first direction in the first group of vias, and a second distance exists between any two adjacent vias in the first direction in the second group of vias; and if the first distance is an integer multiple of the second distance, the concave hole is located between two adjacent vias in the first direction in the first group of vias, where the first direction is the length direction or the width direction.

With reference to the second aspect, in some implementations of the second aspect, the concave hole on the surface of the second side of the substrate layer is in a circular, rectangular, or rhombus shape.

With reference to the second aspect, in some implementations of the second aspect, a depth of the concave hole ranges from 1 micrometer to 30 micrometers.

It should be understood that, for beneficial effects achieved in the second aspect and the corresponding implementations of the second aspect of this application, refer to the beneficial effects achieved in the first aspect and the corresponding implementations of the first aspect of this application. Details are not described again.

### BRIEF DESCRIPTION OF DRAWINGS

FIG. 1 is a schematic flowchart of a through silicon via structure fabrication method according to an embodiment of this application;
FIG. 2A is an example of a side view of a provided wafer;
FIG. 2B is an example of a side view of a wafer in a through silicon via structure fabrication process;
FIG. 2C is another example of a side view of a wafer in a through silicon via structure fabrication process;
FIG. 2D is another example of a side view of a wafer in a through silicon via structure fabrication process;
FIG. 2E is an example of a side view of a through silicon via structure according to this application;
FIG. 3 is an example of a side view of a provided wafer;
FIG. 4 is another example of a side view of a wafer in a through silicon via structure fabrication process;
FIG. 5 shows an example of an equivalent TSV array of a wafer;
FIG. 6A is a schematic diagram of a pattern formed by one via on a surface of a substrate layer;
FIG. 6B is a schematic diagram in which eight concave holes are added around one via;
FIG. 7A is a schematic diagram of patterns formed by a plurality of vias on a surface of a substrate layer;
FIG. 7B is a schematic diagram in which concave holes are added to a plurality of vias;
FIG. 8A is another schematic diagram of patterns formed by a plurality of vias on a surface of a substrate layer;
FIG. 8B is another schematic diagram in which concave holes are added to a plurality of vias;
FIG. 9A is another schematic diagram of patterns formed by a plurality of vias on a surface of a substrate layer;
FIG. 9B is another schematic diagram in which concave holes are added to a plurality of vias;
FIG. 10A is another schematic diagram of patterns formed by a plurality of vias on a surface of a substrate layer;
FIG. 10B is another schematic diagram in which concave holes are added to a plurality of vias;
FIG. 11A is another schematic diagram of patterns formed by a plurality of vias on a surface of a substrate layer;
FIG. 11B is another schematic diagram in which concave holes are added to a plurality of vias;
FIG. 12A is another schematic diagram of patterns formed by a plurality of vias on a surface of a substrate layer;
FIG. 12B is another schematic diagram in which concave holes are added to a plurality of vias;
FIG. 13 is another example of a side view of a wafer in a through silicon via structure fabrication process;
FIG. 14 is an example of a side view of a through silicon via structure according to this application;
FIG. 15A is another example of a side view of a through silicon via structure according to this application;
FIG. 15B is another example of a side view of a through silicon via structure according to this application;
FIG. 15C is another example of a side view of a through silicon via structure according to this application; and
FIG. 15D is another example of a side view of a through silicon via structure according to this application.

### DESCRIPTION OF EMBODIMENTS

The following describes technical solutions of embodiments in this application with reference to the accompanying drawings.

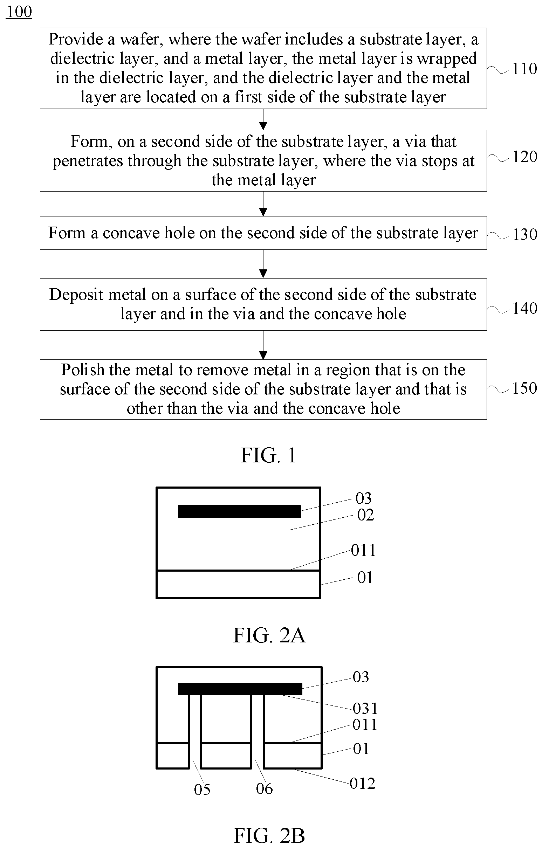

FIG. 1 is a schematic flowchart of a through silicon via structure fabrication method 100 according to an embodiment of this application. FIG. 2A to FIG. 2E are a specific example of a diagram of a technological process corresponding to the method 100. The following describes a through silicon via structure fabrication method 100 shown in FIG. 1 with reference to the technological process shown in FIG. 2A to FIG. 2E. As shown in FIG. 1, the method 100 includes step 110 to step 150.

Step 110: Provide a wafer, where the wafer includes a substrate layer, a dielectric layer, and a metal layer, the metal layer is wrapped in the dielectric layer, and the dielectric layer and the metal layer are located on a first side of the substrate layer.

FIG. 2A shows an example of a side view of the wafer (wafer) corresponding to step 110. As shown in FIG. 2A, the wafer includes a substrate layer 01, a dielectric layer 02, and a metal layer 03. The metal layer 03 is wrapped in the dielectric layer 02, and both the dielectric layer 02 and the metal layer 03 are located on a first side of the substrate layer 01, for example, on a part above a first surface 011 of the substrate layer 01 (that is, a surface of the first side).

For example, the substrate layer in this application may be a semiconductor substrate layer, for example, a silicon substrate, a germanium silicon substrate, or a sapphire substrate. This is not limited.

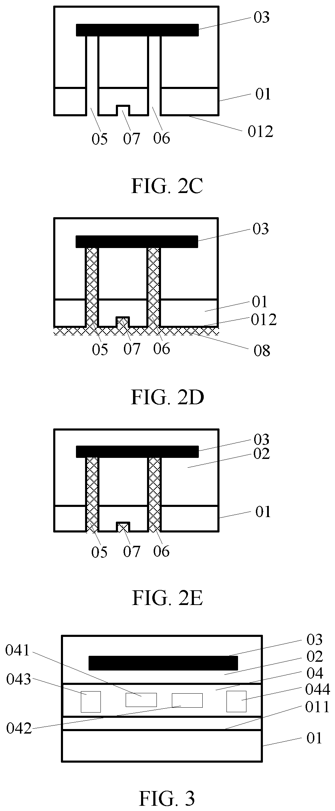

It can be understood that the wafer may further include a device layer, and the device layer may be located between the substrate layer and the metal layer. For example, the device layer may include a source region, a drain region, a well region, and the like. This is not limited in this application. FIG. 3 shows an example of a structure of a wafer. As shown in FIG. 3, a device layer 04 may be located between the substrate layer 01 and the metal layer 03 (or the dielectric layer 02), and the device layer 04 may include a source region 041, a drain region 042, a well region 043, and a well region 044.

It should be understood that FIG. 3 shows the example of the wafer, but this does not constitute any limitation on this application. The wafer in this application may be alternatively a wafer of a structure other than that in FIG. 3. This falls within the protection scope of this application.

In addition, the wafer may further include other layer structures, for example, a buffer layer and a barrier layer. These layer structures may be located on the first side of the substrate layer, for example, located between the dielectric layer and the substrate layer. This is not limited in this application.

In step 110, TSV fabrication pre-processing, such as substrate thinning processing (for example, performing thinning from hundreds of µm to dozens of µm) and polishing processing, may be further performed on the wafer. This is not limited in this application. In an example, the polishing may be chemical mechanical polishing (chemical mechanical polishing, CMP), physical polishing, or the like. This is not limited. The chemical mechanical polishing may also be referred to as chemical mechanical planarization. This is not limited in this application.

Step 120: Form, on a second side of the substrate layer, a via that penetrates through the substrate layer, where the via stops at the metal layer. There may be one or more vias. This is not limited.

FIG. 2B shows an example of a side view of the wafer corresponding to step 120. As shown in FIG. 2B, based on FIG. 2A, vias 05 and 06 may be further formed on the wafer starting from a second side of the substrate layer 01. The vias 05 and 06 penetrate through the substrate layer 01, that is, connect two opposite surfaces of the substrate layer 01, for example, the first surface 011 and a second surface 012 (that is, a surface of the second side). Still with reference to FIG. 2B, the vias 05 and 06 finally stop at the metal layer 03.

It should be understood that in FIG. 2B, an example in which only the vias 05 and 06 are formed is used for description. This application is not limited thereto. For example, alternatively, in step 120, only one via may be formed, or more vias may be formed.

For example, in this application, the via may be fabricated by using processes such as a photoetching process and an etching process. The etching process is, for example, deep reactive ion etching (deep reactive ion etching, DRIE) or deep plasma etching. This is not limited in this application.

In a manner of stopping the via at the metal layer, etching time (or etching time and an etching rate) may be controlled, so that the metal layer is exposed from inside the via when the etching process for the via ends.

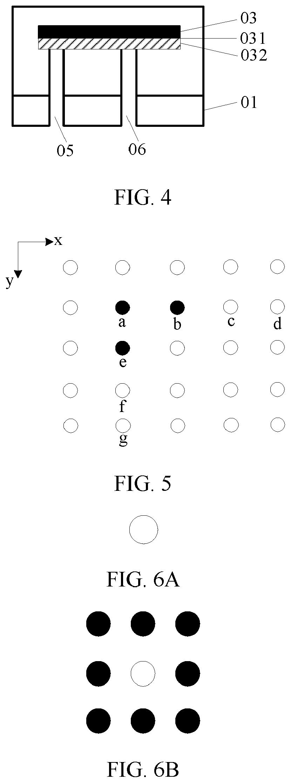

In another manner of stopping the via at the metal layer, the wafer may include an etching stop layer, and the etching stop layer is located between the substrate layer and the metal layer, for example, may be connected to a surface of the metal layer (for example, a lower surface 031 of the metal layer 03 in FIG. 2B). In this case, etching time (or etching time and an etching rate) is controlled, so that after a first time period expires, the via stops at the etching stop layer. FIG. 4 shows an example in which vias stop at an etching stop layer. As shown in FIG. 4, the vias 05 and 06 stop at the etching stop layer 032 below the lower surface 031 of the metal layer 03. In this case, the etching stop layer 032 is exposed from inside the vias 05 and 06. Then, the etching stop layer 032 may be etched. For example, etching time (or etching time and an etching rate) may be controlled, so that after a second time period expires, the vias 05 and 06 stop at the metal layer 03. In this case, the metal layer is exposed from inside the vias 05 and 06, that is, a structure shown in FIG. 2B is obtained.

Therefore, an etching depth can be effectively controlled by disposing the etching stop layer. This helps avoid an excessively deep or excessively shallow etching depth. In an example, when the etching depth is excessively deep, the metal layer may be completely etched. When the etching depth is excessively shallow, etching may be stopped before the metal layer is exposed from inside the via.

In this embodiment of this application, the via generated in step 120 is used to form a TSV, and therefore may also be referred to as a TSV hole or a TSV deep hole. This is not limited in this application.

After the via is formed in step 120, on the surface of the second side of the substrate layer 01 (that is, the second surface 012), the via forms a pattern. The pattern is a top view formed by the via on the second surface 012 of the substrate layer 01. In some embodiments, it may mean that a via is corresponding to a TSV formed by the via, or a pattern formed by a via on the surface of the second side of the substrate layer is corresponding to a TSV formed by the via.

In this embodiment of this application, patterns formed by vias on the surface of the second side of the substrate layer are not limited. For example, TSVs corresponding to the patterns may be a part of a TSV array or a complete TSV array, or TSVs corresponding to the patterns may include at least two parts of TSV arrays having different pitches, or TSVs corresponding to the patterns may be isolation (isolation) TSVs, or a distance between two adjacent TSVs in TSVs corresponding to the patterns is different from a distance between other two adjacent TSVs in the TSVs corresponding to the patterns, or a TSV array formed by TSVs corresponding to the patterns may be a TSV array verified by a vendor (vendor) or may not be a TSV array verified by a vendor.

A TSV array may include at least two TSVs in a width direction and at least two TSVs in a length direction. A distance between any two adjacent TSVs in the length direction is equal to a distance between any other two adjacent TSVs in the length direction (the distance may be referred to as a pitch of the TSV array in the length direction), and a distance between any two adjacent TSVs in the width direction is equal to a distance between any other two adjacent TSVs in the width direction (the distance may be referred to as a pitch of the TSV array in the width direction). In other words, the TSV array may be an array formed by at least two TSVs with invariable pitches in both the width direction and the length direction. For example, in the TSV array, when a quantity of TSVs in the width direction is m, and a quantity of TSVs in the length direction is n, the TSV array may be referred to as an m×n TSV array. Both m and n are positive integers.

It should be noted that in the TSV array, the quantity of TSVs in the width direction is equal to or unequal to the quantity of TSVs in the length direction, and a distance between any two adjacent TSVs in the length direction may be equal to or unequal to a distance between any two TSVs in the width direction. This is not limited in this application.

It should be noted that in this embodiment of this application, a technological process of forming a via may be slightly adjusted depending on an actual situation. This is not limited in this embodiment of this application.

Step 130: Form a concave hole on the second side of the substrate layer. There may be one or more concave holes. This is not limited.

FIG. 2C shows an example of a side view of the wafer corresponding to step 130. As shown in the figure, based on FIG. 2B, a concave hole 07 may be further formed on the second side of the substrate layer 01 (that is, starting from the second surface 012). Optionally, the concave hole 07 may not penetrate through the substrate layer 01. It should be understood that in FIG. 2C, an example in which only the concave hole 07 is formed is used for description. This application is not limited thereto. For example, a plurality of concave holes may be alternatively formed.

For example, in this application, the concave hole may be fabricated by using the processes such as the photoetching process and the etching process. Specifically, for the processes such as the photoetching process and the etching process, refer to the foregoing descriptions. Details are not described again.

A shape of the concave hole is not limited in this embodiment of this application. For example, a shape of the concave hole may be a cylinder, a quadrangular prism, a trapezoid, or another shape. In some specific examples, a pattern (that is, a top view of the concave hole) formed by the concave hole on the surface of the second side of the substrate layer may be in a circular, rectangular, rhombus, or another shape. This is not limited. It can be understood that the shape selected for the concave hole (or the top view of the concave hole) needs to make processing of a subsequent process (for example, CMP) as convenient as possible, or have a low process risk, for example, have consistent flatness, roughness, and no remaining metal.

It should be noted that, in some embodiments, on the surface of the second side of the substrate layer, the patterns formed by the concave hole and the via may be the same as or similar to each other, for example, both are circles with a same diameter or similar diameters. This is not limited in this application.

Alternatively, in some other embodiments, on the surface of the second side of the substrate layer, the pattern formed by the concave hole may have a different shape or different dimensions from the pattern formed by the via. For example, the pattern formed by the via is a circle, and the pattern formed by the concave hole is a rhombus, a rectangle, or the like. This is not limited in this application.

A depth of the concave hole is not limited in this embodiment of this application. For example, the depth of the concave hole may range from 1 micrometer (µm) to 30 micrometers, for example, may be 2 µm. It should be noted that the depth of the concave hole does not need to be set excessively deep, to avoid affecting component performance or increasing technology difficulty.

In this embodiment of this application, the concave hole may be used to form a dummy pad (dummy pad). The concave hole may also be referred to as a dummy hole. Correspondingly, a location of the concave hole is corresponding to a location of the dummy pad (or a location of a pad).

In some embodiments, after the vias and the concave holes are formed in step 120 and step 130, on the surface of the second side of the substrate layer, the patterns formed by the concave holes may be located between or around the patterns formed by the vias. In this case, each via forms a first pattern on the surface of the second side of the substrate layer, and each concave hole forms a second pattern on the surface of the second side of the substrate layer. In other words, at least one via may form at least one first pattern, and at least one concave hole may form at least one second pattern.

In some optional embodiments, at least one first pattern and at least one second pattern on the surface of the second side have a same adjacent-pattern distance in a width direction, and/or a same adjacent-pattern distance in a length direction. In this case, a TSV corresponding to the at least one first pattern and a dummy pad corresponding to the at least one second pattern may be jointly equivalent to a TSV array constructed in a TSV structure fabrication process. In other words, the TSV corresponding to the at least one first pattern and the dummy pad corresponding to the at least one second pattern may be jointly referred to as an equivalent TSV array of the wafer.

FIG. 5 shows an example of an equivalent TSV array of a wafer. Black filling patterns are corresponding to concave holes or dummy pads formed by concave holes, and white filling patterns are corresponding to vias or TSVs formed by vias. As shown in FIG. 5, because concave holes are disposed between vias or around vias, the any two adjacent patterns may include three possible cases: a pattern corresponding to a concave hole and a pattern of a via adjacent to the concave hole (for example, patterns b and c in an x direction, and patterns e and f in a y direction), or a pattern corresponding to a concave hole and a pattern of another concave hole adjacent to the concave hole (for example, patterns a and b in the x direction, and patterns a and e in the y direction), or a pattern corresponding to a via and a pattern of another via adjacent to the via (for example, patterns c and d in the x direction, and patterns f and g in the y direction). The x direction may be the width direction, and the y direction may be the length direction.

Still with reference to FIG. 5, in the x direction, distances between the patterns a and b, between the patterns b and c, and between the patterns c and d are all equal to each other, and are all pitches of the equivalent TSV array of the wafer in the x direction. In the y direction, distances between the patterns a and e, between the patterns e and f, and between the patterns f and g are all equal to each other, and are all pitches of the equivalent TSV array of the wafer in the y direction. The pitch of the equivalent TSV array in the x direction may be equal to or unequal to the pitch of the equivalent TSV array in the y direction. This is not limited.

The following describes six cases of locations of concave holes and locations of vias on the surface of the second side of the substrate layer with reference to the accompanying drawings. In the following accompanying drawings, an example is used for description in which black filling patterns are corresponding to concave holes or dummy pads formed by concave holes, and white filling patterns are corresponding to vias or TSVs formed by vias.

In a first possible case, when there is one via, there are eight concave holes, and the eight concave holes are evenly distributed around the via.

FIG. 6A shows an example of a pattern formed by one via on a surface of a substrate layer. In this case, the via may form an isolation TSV FIG. 6B shows an example of the via in FIG. 6A and eight added concave holes. The eight concave holes are evenly distributed around the via. In FIG. 6B, in patterns corresponding to the eight concave holes and the pattern corresponding to the via, a distance between any two adjacent patterns in the length direction is equal to a distance between any other two adjacent patterns in the length direction, and a distance between any two adjacent patterns in the width direction is equal to a distance between any other two adjacent patterns in the width direction. In other words, the patterns in FIG. 6B are a 3×3 equivalent TSV array of the wafer.

In some optional embodiments, concave holes of another quantity may be alternatively added around the one via. In patterns formed by these concave holes on the surface of the substrate layer and a pattern formed by the via, a distance between any two adjacent patterns in the length direction is equal to a distance between any other two adjacent patterns in the length direction, and a distance between any two adjacent patterns in the width direction is equal to a distance between any other two adjacent patterns in the width direction. For example, there may be 15 added concave holes, so that the equivalent TSV array of the wafer is a 4×4 TSV array. For another example, there may be 11 added concave holes, so that the wafer has a 4×3 equivalent TSV array.

In a second possible case, when there are a plurality of vias, TSVs corresponding to the plurality of vias are a part of a TSV array, for example, TSVs left after one or some TSVs are removed from the TSV array. In this case, the concave hole may be at a location corresponding to the one or some removed TSVs, so that the concave hole and the vias jointly form a complete array, and the wafer has an equivalent TSV array.

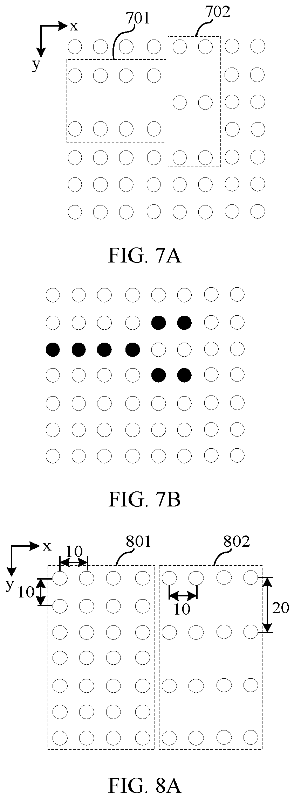

FIG. 7A shows an example of patterns formed by a plurality of vias on a surface of a substrate layer. As shown in FIG. 7A, vias in each of dashed-line boxes 701 and 702 are four fewer than those in a complete TSV array. In other words, TSVs corresponding to the vias are TSVs left after four TSVs are removed from the dashed-line box 701 in the TSV array and after four TSVs are removed from the dashed-line box 702 in the TSV array. FIG. 7B shows an example of the plurality of vias in FIG. 7A and eight added concave holes. Four concave holes are at locations corresponding to the four TSVs removed from the dashed-line box 701, and the other four concave holes are at locations corresponding to the four TSVs removed from the dashed-line box 702. In FIG. 7B, in patterns corresponding to the concave holes and the patterns corresponding to the vias, a distance between any two adjacent patterns in the length direction is equal to a distance between any other two adjacent patterns in the length direction, and a distance between any two adjacent patterns in the width direction is equal to a distance between any other two adjacent patterns in the width direction. In other words, the patterns in FIG. 7B are the equivalent TSV array of the wafer.

In a third possible case, when there are a plurality of vias, the plurality of vias include a first group of vias and a second group of vias; on the surface of the substrate layer, a first distance exists between any two adjacent vias in a first direction in the first group of vias, and a second distance exists between any two adjacent vias in the first direction in the second group of vias; and if the first distance is an integer multiple of the second distance, the concave hole is located between two adjacent vias in the first direction in the first group of vias in this case, where the first direction is the length direction or the width direction.

In other words, when patterns formed by the vias on a lower surface of the substrate layer include first group of patterns and second group of patterns, and a first distance between any two adjacent patterns in the first direction in the first group of patterns is an integer multiple of a second distance between any two adjacent patterns in the first direction in the second group of patterns, the pattern corresponding to the concave hole may be located between two adjacent patterns in the first direction in the first group of patterns, so that after the concave hole is added, a distance between two adjacent patterns in the first direction in the pattern corresponding to the concave hole of the first group of patterns is also the second distance. In this way, for patterns formed on the lower surface of the entire substrate layer, a distance between any two adjacent patterns in the first direction is equal to a distance between any other two adjacent patterns in the first direction, namely, the second distance.

FIG. 8A shows another example of patterns formed by a plurality of vias on a surface of a substrate layer. As shown in FIG. 8A, vias in a dashed-line box 802 are first group of vias, and corresponding patterns are first group of patterns; and vias in a dashed-line box 801 are second group of vias, and corresponding patterns are second group of patterns. In a specific example, in the first group of patterns (or the first group of vias), a distance between two adjacent patterns (or vias) in the x direction is 10 µm, and a distance between two adjacent patterns (or vias) in the y direction is 20 µm. In other words, a TSV array corresponding to the first group of patterns (or the first group of vias) is a 10 µm×20 µm array. In the second group of patterns (or the second group of vias), a distance between two adjacent patterns (or vias) in the x direction is 10 µm, and a distance between two adjacent patterns (or vias) in the y direction is also 10 µm. In other words, a TSV array corresponding to the second group of patterns (or the second group of vias) is a 10 µm×10 µm array. In this case, in the y direction, the distance between two adjacent patterns (or vias) in the second group of patterns (or the second group of vias) is twice the distance between two adjacent patterns (or vias) in the first group of patterns (or the first group of vias).

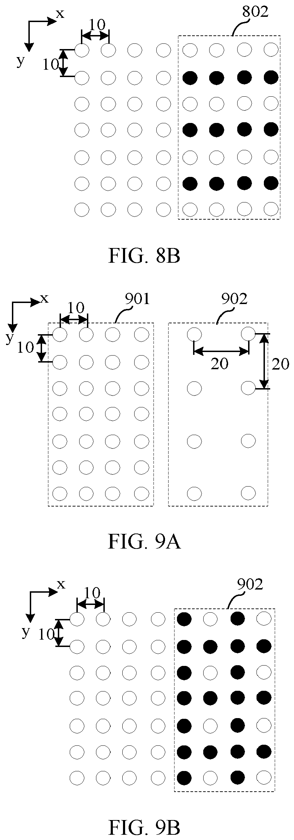

FIG. 8B shows an example of the plurality of vias in FIG. 8A and added concave holes. As shown in FIG. 8B, one row of concave holes are separately added between two adjacent rows of vias in the y direction in the dashed-line box 802, so that the distance between adjacent patterns in the y direction in the dashed-line box 802 is 10 µm. For the added concave hole, a distance between adjacent concave holes in the x direction is 10 µm. In this way, in FIG. 8B, a TSV array that is corresponding to patterns corresponding to the concave holes and the patterns corresponding to the vias is a 10 µm×10 µm array. In this case, the patterns in FIG. 8B are the equivalent TSV array of the wafer, that is, a 10 µm×10 µm TSV array.

FIG. 9A shows another example of patterns formed by a plurality of vias on a surface of a substrate layer. As shown in FIG. 9A, vias in a dashed-line box 902 are first group of vias, and corresponding patterns are first group of patterns; and vias in a dashed-line box 901 are second group of vias, and corresponding patterns are second group of patterns. In a specific example, in the first group of patterns (or the first group of vias), a distance between two adjacent patterns (or vias) in the x direction is 20 µm, and a distance between two adjacent patterns (or vias) in the y direction is 20 µm. In other words, a TSV array corresponding to the first group of patterns (or the first group of vias) is a 20 µm×20 µm array. In the second group of patterns (or the second group of vias), a distance between two adjacent patterns (or vias) in the x direction is 10 µm, and a distance between two adjacent patterns (or vias) in the y direction is also 10 µm. In other words, a TSV array corresponding to the second group of patterns (or the second group of vias) is a 10 µm×10 µm array. In this case, in both the x direction and the y direction, the distance between two adjacent patterns (or vias) in the second group of patterns (or the second group of vias) is twice the distance between two adjacent patterns (or vias) in the first group of patterns (or the first group of vias).

FIG. 9B shows an example of the plurality of vias in FIG. 9A and added concave holes. As shown in FIG. 9B, concave holes are separately added between two adjacent rows of vias in the x direction and the y direction in the dashed-line box 902, so that in the dashed-line box 902, the distance between adjacent patterns in the y direction is 10 µm, and the distance between adjacent patterns in the x direction is 10 µm. In this way, in FIG. 9B, a TSV array that is corresponding to patterns corresponding to the concave holes and the patterns corresponding to the vias is a 10 µm×10 µm array. In this case, the patterns in FIG. 9B are the equivalent TSV array of the wafer, that is, a 10 µm×10 µm TSV array.

In a fourth possible case, on the surface of the substrate layer, when a first distance between any two adjacent vias in a first direction in first group of vias is greater than a second distance between any two adjacent vias in the first direction in second group of vias, but the first distance is not an integer multiple of the second distance, at least one concave hole can still be disposed between the first group of vias, so that the patterns formed by the concave hole and the vias on the surface of the substrate layer look as regular or even as possible.

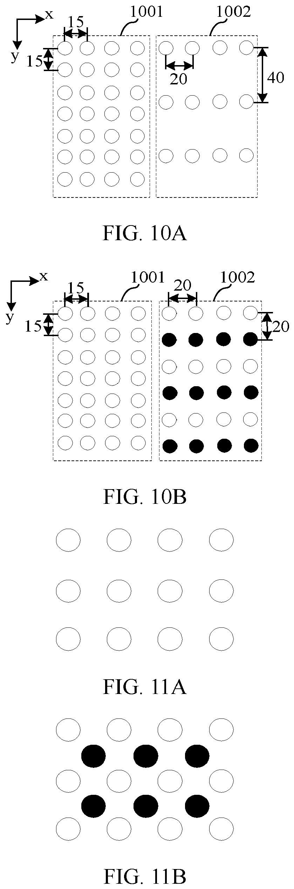

FIG. 10A shows another example of patterns formed by a plurality of vias on a surface of a substrate layer. As shown in FIG. 10A, vias in a dashed-line box 1002 are first group of vias, and corresponding patterns are first group of patterns; and vias in a dashed-line box 1001 are second group of vias, and corresponding patterns are second group of patterns. In a specific example, in the first group of patterns (or the first group of vias), a distance between two adjacent patterns (or vias) in the x direction is 20 µm, and a distance between two adjacent patterns (or vias) in the y direction is 40 µm. In other words, a TSV array corresponding to the first group of patterns (or the first group of vias) is a 20 µm×40 µm array. In the second group of patterns (or the second group of vias), a distance between two adjacent patterns (or vias) in the x direction is 15 µm, and a distance between two adjacent patterns (or vias) in the y direction is also 15 µm. In other words, a TSV array corresponding to the second group of patterns (or the second group of vias) is a 15 µm×15 µm array. In this case, in both the x direction and the y direction, the distance between two adjacent patterns (or vias) in the second group of patterns (or the second group of vias) is greater than the distance between two adjacent patterns (or vias) in the first group of patterns (or the first group of vias), and is not an integer multiple of the distance between two adjacent patterns (or vias) in the first group of patterns (or the first group of vias).

FIG. 10B shows an example of the plurality of vias in FIG. 10A and added concave holes. As shown in FIG. 10B, one row of concave holes are separately added between two adjacent rows of vias in the y direction in the dashed-line box 1002, so that the distance between adjacent patterns in the y direction in the dashed-line box 1002 is 20 µm. For the added concave hole, a distance between adjacent concave holes in the x direction is 20 µm. In this way, in FIG. 10B, an equivalent TSV array that is corresponding to patterns corresponding to the concave holes and the patterns corresponding to the vias in the dashed-line box 1002 is a 20 µm×20 µm array. In this case, a pitch of the TSV array corresponding to the dashed-line box 1002 is similar to that of a TSV array corresponding to the dashed-line box 1001, so that on the surface of the substrate layer, the patterns formed by the concave holes and the vias in the dashed-line box 1002 and the patterns formed by the concave holes and the vias in the dashed-line box 1001 look as regular or even as possible.

It should be noted that, in FIG. 10B, an example is used for description in which the equivalent TSV array that is corresponding to the patterns corresponding to the concave holes and the patterns corresponding to the vias in the dashed-line box 1002 is a 20 µm×20 µm array. However, this application is not limited thereto. For example, the equivalent TSV array may be alternatively a 10 µm×20 µm array or another array. This is not limited.

In a fifth possible case, when patterns corresponding to vias are irregular, that is, TSVs corresponding to the vias are not a TSV array, for example, when a distance between adjacent vias in the width direction or the length direction is different from a distance between other adjacent vias in the width direction or the length direction, the concave hole may be added between the vias, so that the patterns formed by the concave hole and the vias on the surface of the substrate layer look as regular or even as possible.

In a sixth possible case, when TSVs corresponding to vias are a TSV array, the concave hole can still be added between the vias. For example, when a TSV array corresponding to the vias is not the TSV array verified by the vendor, the concave hole may be added, so that an equivalent TSV array corresponding to the patterns formed by the concave hole and the vias is the TSV array verified by the vendor. For another example, when a TSV array corresponding to the vias is a TSV array with a large pitch, because the vias are sparse, metal is not evenly distributed during subsequent polishing of the metal. In this case, the concave hole is added, so that an equivalent TSV array pitch of the wafer is small. This can help distribute metal more evenly during subsequent polishing, thereby reducing CMP difficulty.

FIG. 11A and FIG. 11B show an example in which concave holes are added when TSVs corresponding to vias are a TSV array. FIG. 11A shows an example of the TSV array corresponding to the vias. In FIG. 11A, concave holes in same shapes as the vias may be added between the vias, to obtain patterns formed by the concave holes and the vias shown in FIG. 11B.

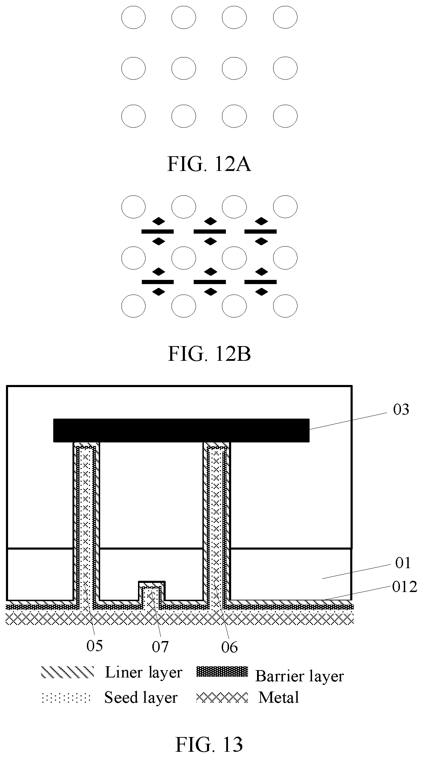

FIG. 12A and FIG. 12B show another example in which concave holes are added when TSVs corresponding to vias are a TSV array. FIG. 12A shows an example of the TSV array corresponding to the vias. In FIG. 12A, rhombus or rectangular concave holes may be added between the vias, to obtain patterns formed by the concave holes and the vias shown in FIG. 12B.

It should be noted that, in FIG. 11B and FIG. 12B, an example is used for description in which a concave hole is added to a central location of every four adjacent vias that can form a rectangle. However, this embodiment of this application is not limited thereto. For example, the concave holes may be alternatively located between adjacent vias in the width direction or the length direction, or at another location.

It should also be noted that a sequence of performing step 120 and step 130 is not limited in this embodiment of this application. For example, step 120 may be performed before step 130, step 120 may be performed after step 130, or step 120 and step 130 may be performed simultaneously.

Step 140: Deposit metal on the surface of the second side of the substrate layer and in the via and the concave hole. In this way, the metal in the via may form a via pillar connected to the metal layer.

FIG. 2D shows an example of a side view of the wafer corresponding to step 140. As shown in FIG. 2D, based on FIG. 2C, metal 08 (that is, a shadow part in the figure) may be deposited on the second surface 012 of the substrate layer 01, the vias 05 and 06, and the concave hole 07. In this case, both the metal in the via 05 and the metal in the via 06 may form a via pillar, the concave hole 07 is also filled with metal, and a metal film layer is formed on the second surface 012.

In an example, the metal film layer may include Cu metal, or may include other metal such as Ag and Au. This is not limited.

In a possible implementation, a liner (liner) layer, a barrier (barrier) layer, and a seed layer may be sequentially formed on the surface of the second side of the substrate layer and in the via and the concave hole; and the metal may be deposited on the seed layer by using an electroplating process. In this way, the metal is deposited on the surface of the second side of the substrate layer and in the via and the concave hole. FIG. 13 shows an example of a side view of a wafer. A liner layer, a barrier layer, a seed layer, and metal are sequentially formed on the second surface 012 of the substrate layer 01 and in the vias 05 and 06 and the concave hole 07.

The liner layer can improve flatness and a stress buffer of an etching surface. In addition, the liner layer also has a function of the barrier layer. The barrier layer may be configured to prevent metal from spreading, for example, prevent metal from spreading to Si or SiO2, to improve component performance. The seed layer is configured to conduct electricity, to deposit metal in an electroplating manner.

In an example, the liner layer, the barrier layer, or the seed layer may be fabricated by using processes such as chemical vapor deposition (chemical vapour deposition, CVD) and atomic layer deposition (atomic layer deposition, ALD). This is not limited in this application.

In an example, the liner layer may include SiO₂, and the barrier layer may include Ta/N or Ta. This is not limited in this application.

In an example, when the metal film layer may include Cu, the seed layer may include Cu. This is not limited in this application.

Step 150: Polish the metal to remove metal in a region that is on the surface of the second side of the substrate layer and that is other than the via and the concave hole.

In an example, the polishing the metal may be starting performing polishing from the metal deposited on the second side of the substrate layer. Optionally, when there is no remaining metal on the surface of the second side of the substrate layer after polishing, the second side of the substrate layer can still continue to be polished. This is not limited in this application.

FIG. 2E shows an example of a side view of the wafer corresponding to step 150. As shown in FIG. 2E, based on FIG. 2D, polishing may be performed starting from metal on the second surface 012 of the substrate layer 01, to remove metal in a region that is on the second surface 012 of the substrate layer and that is other than the vias 05 and 06 and the concave hole 07. In an example, in FIG. 2E, polishing may be kept until polishing performed on the second surface 012 of the substrate layer 01 ends. In this case, there is no remaining metal on the second surface 012 except regions corresponding to the vias 05 and 06 and the concave hole 07, and heights of metal pillars in the vias 05 and 06 and the concave hole 07 are flush with that of the second surface 012.

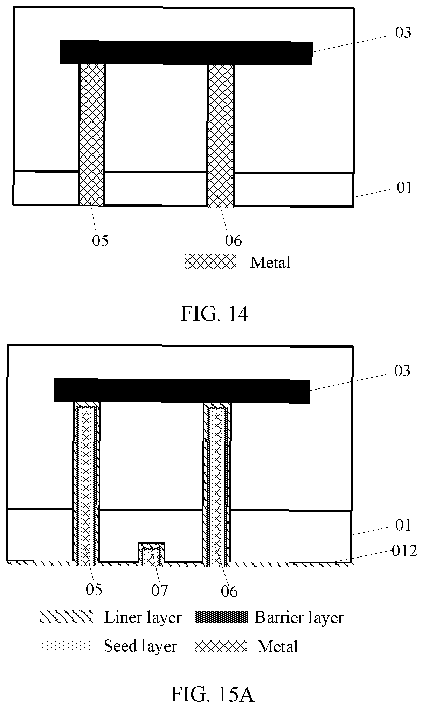

In some possible implementations, when polishing performed on the second surface 012 of the substrate layer 01 ends, polishing may alternatively continue to be performed along the second side of the substrate layer 01 for a period of time and then stop. In this case, the substrate layer 01 is thinned through polishing, and depths of the vias 05 and 06 and the concave hole 07 are correspondingly reduced. In a possible case, as shown in FIG. 14, after polishing is performed for a period of time, the depth of the concave hole 07 is reduced to 0. In other words, a region corresponding to the concave hole 07 at the substrate layer 01 is flush with a newly formed surface of the second side of the substrate layer 01. It can be understood that in a process of polishing the substrate layer 01, heights of metal pillars in the vias 05 and 06 are always flush with that of the newly formed surface of the second side of the substrate layer 01.

In some optional embodiments, when the liner layer, the barrier layer, the seed layer, and the metal are sequentially formed on the surface of the second side of the substrate layer and in the via and the concave hole (that is, corresponding to the wafer shown in FIG. 13), in a possible implementation, as shown in FIG. 15A, when polishing is performed starting from metal on the second surface 012 of the substrate layer 01, polishing may be kept until polishing performed at the liner layer ends. In this case, heights of metal pillars in the vias 05 and 06 and the concave hole 07 are flush with that of the liner layer.

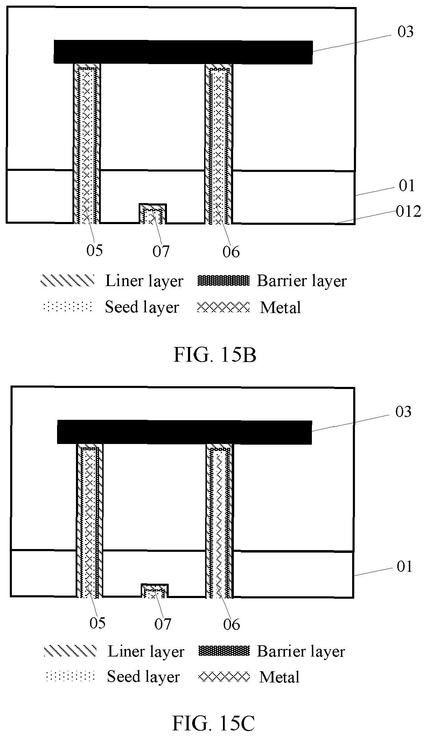

In another possible implementation, as shown in FIG. 15B, when polishing is performed starting from metal on the second surface 012 of the substrate layer 01, polishing may be kept until polishing performed on the second surface 012 of the substrate layer 01 ends. In this case, heights of metal pillars in the vias 05 and 06 and the concave hole 07 are flush with that of the second surface 012 of the substrate layer 01.

In another possible implementation, as shown in FIG. 15C, when polishing is performed starting from metal on the second surface 012 of the substrate layer 01, polishing may continue to be performed at the substrate layer 01 when polishing performed on the second surface 012 of the substrate layer 01 ends. In this case, the substrate layer 01 is thinned through polishing, and depths of the vias 05 and 06 and the concave hole 07 are correspondingly reduced.

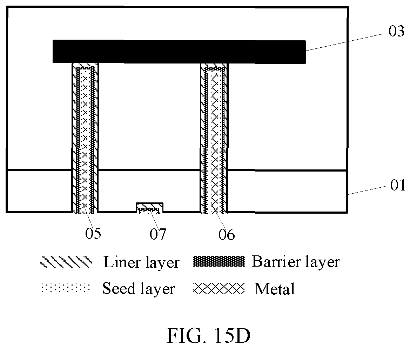

In another possible implementation, as shown in FIG. 15D, polishing continues to be performed at the substrate layer 01 when polishing performed on the second surface 012 of the substrate layer 01 ends, until there is no remaining metal in a via 07. In this case, the concave hole 07 may include a liner layer, a barrier layer, and a seed layer. In a process of polishing the substrate layer 01, heights of metal pillars in the vias 05 and 06 are always flush with that of a newly formed surface of the second side of the substrate layer 01.

It can be learned from the foregoing descriptions that, after the polishing in step 150 ends, there may be remaining metal in the concave hole, for example, which is corresponding to the foregoing cases in FIG. 2E, FIG. 15A, FIG. 15B, and FIG. 15C. This can ensure that there is always remaining metal in the concave hole in a polishing process. In other words, the depth of the concave hole cannot be excessively shallow, to ensure that there is always remaining metal in the concave hole in the polishing process.

Alternatively, there may be remaining metal in the concave hole in the polishing process in step 150, and there may be no remaining metal in the concave hole after the polishing in step 150 ends, for example, which is corresponding to the case in FIG. 15D.

Alternatively, there may be remaining metal in the concave hole in the polishing process in step 150, and there may be no concave hole at the substrate layer 01 after the polishing in step 150 ends, for example, which is corresponding to the case in FIG. 14.

In an example, in step 150, the polishing may be chemical mechanical polishing (namely, CMP) or physical polishing. This is not limited in this embodiment of this application.

It should be noted that in this embodiment of this application, step 150 may be performed by using a standard processing technology. For example, annealing (anneal) processing may be performed before the CMP, or a plurality of times of annealing and CMP processing, such as anneal-CMP-anneal-CMP processing, may be performed. This is not limited in this application.

In some embodiments, after the CMP is completed, a subsequent processing procedure may be performed, for example, a redistributed layer (redistributed layer, RDL) process may be implemented. This is not limited in this application.

In this embodiment of this application, when through silicon vias are formed on the wafer, the concave hole and the via that is used to form a through silicon via may be formed on one side of the substrate layer, and on the side of the substrate layer, the metal is deposited on the surface of the substrate layer and in the via and the concave hole. In this way, when polishing is performed on the metal on the surface of the substrate layer, disposing the concave hole can add metal to a place at which there is no via at the substrate layer. This helps evenly distribute metal as much as possible in the polishing process, thereby improving consistency and reliability of a polishing technology.

For example, in this embodiment of this application, the TSV corresponding to the via may not be a TSV array or may not be the TSV array verified by the vendor. By adding the concave hole at the substrate layer, in a subsequent polishing technology, the TSVs of the wafer can be equivalent to a TSV array or the TSV array verified by the vendor. Therefore, in comparison with a TSV fabrication solution in which no concave hole is formed, metal (metal) can be distributed more evenly in the subsequent polishing technology in this embodiment of this application. This reduces polishing complexity. Further, because the TSV corresponding to the via in this application may not be a TSV array or may not be the TSV array verified by the vendor, a TSV pattern can be flexibly designed depending on a product requirement in this application, to increase a process window.

An embodiment of this application further provides a through silicon via structure, including: a substrate layer, a dielectric layer, a metal layer, a via, and a concave hole, where the metal layer is wrapped in the dielectric layer, and the dielectric layer and the metal layer are located on a first side of the substrate layer; the via penetrates through the substrate layer from a second side of the substrate layer, and stops at the metal layer; the concave hole is formed on the second side of the substrate layer; and metal is deposited in the via and the concave hole.

In an example, the through silicon via structure may be, for example, the structure shown in FIG. 2E, FIG. 15A, FIG. 15B, FIG. 15C, or FIG. 15D. Specifically, for the substrate layer, the dielectric layer, the metal layer, the via, and the concave hole, refer to the foregoing descriptions. Details are not described again.

The dielectric layer and the metal layer may be located on a part above the substrate layer, and then the concave hole may be located on a lower surface of the substrate layer. When the metal layer or another layer structure is formed on the lower surface of the substrate layer, the metal in the concave hole can help improve adhesiveness of the lower surface of the substrate layer.

In addition, the metal in the concave hole can help improve thermal conductivity of the substrate layer.

It should be understood that in embodiments described in this specification, "first", "second", and various numbers are merely used for differentiation for ease of description, but are not used to limit the scope of embodiments of this application.

It should also be understood that sequence numbers of the foregoing processes do not mean execution sequences in embodiments of this application. The execution sequences of the processes need to be determined based on functions and internal logic of the processes, and should not be construed as any limitation on the implementation processes of embodiments of this application.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A through silicon via structure fabrication method, comprising:
providing a wafer, wherein the wafer comprises a substrate layer, a dielectric layer, and a metal layer, the metal layer is wrapped in the dielectric layer, and the dielectric layer and the metal layer are located on a first side of the substrate layer;
forming, on a second side of the substrate layer, a via that penetrates through the substrate layer, wherein the via stops at the metal layer;
forming a concave hole on the second side of the substrate layer;
depositing metal on a surface of the second side of the substrate layer and in the via and the concave hole; and
polishing the metal to remove metal in a region that is on the surface of the second side of the substrate layer and that is other than the via and the concave hole.

2. The method according to claim 1, wherein there is remaining metal in the concave hole after the polishing.

3. The method according to claim 1 or 2, wherein there is at least one via, there is at least one concave hole, each via forms a first pattern on the surface of the second side of the substrate layer, each concave hole forms a second pattern on the surface of the second side of the substrate layer, and at least one first pattern and at least one second pattern on the surface of the second side have a same adjacent-pattern distance in a width direction, and/or a same adjacent-pattern distance in a length direction.

4. The method according to any one of claims 1 to 3, wherein when there is one via, there are eight concave holes, and the eight concave holes are evenly distributed around the via.

5. The method according to any one of claims 1 to 3, wherein there are a plurality of vias, and the plurality of vias comprise a first group of vias and a second group of vias; on the surface of the second side of the substrate layer, a first distance exists between any two adjacent vias in a first direction in the first group of vias, and a second distance exists between any two adjacent vias in the first direction in the second group of vias; and if the first distance is an integer multiple of the second distance, the concave hole is located between two adjacent vias in the first direction in the first group of vias, wherein the first direction is the length direction or the width direction.

6. The method according to any one of claims 1 to 5, wherein the concave hole on the surface of the second side of the substrate layer is in a circular, rectangular, or rhombus shape.

7. The method according to any one of claims 1 to 6, wherein a depth of the concave hole ranges from 1 micrometer to 30 micrometers.

8. The method according to any one of claims 1 to 7, wherein the depositing metal on a surface of the second side of the substrate layer and in the via and the concave hole comprises:
sequentially forming a liner layer, a barrier layer, and a seed layer on the surface of the second side of the substrate layer and in the via and the concave hole; and
depositing the metal on the seed layer by using an electroplating process.

9. The method according to claim 8, wherein the barrier layer comprises Ta or TaN.

10. The method according to claim 8 or 9, wherein the seed layer comprises Cu.

11. The method according to any one of claims 1 to 10, wherein the metal comprises Cu.

12. A through silicon via structure, comprising:
a substrate layer, a dielectric layer, a metal layer, a via, and a concave hole, wherein
the metal layer is wrapped in the dielectric layer, and the dielectric layer and the metal layer are located on a first side of the substrate layer; the via penetrates through the substrate layer from a second side of the substrate layer, and stops at the metal layer; the concave hole is formed on the second side of the substrate layer; and metal is deposited in the via and the concave hole.

13. The through silicon via structure according to claim 12, wherein there is at least one via, there is at least one concave hole, each via forms a first pattern on a surface of the second side of the substrate layer, each concave hole forms a second pattern on the surface of the second side of the substrate layer, and at least one first pattern and at least one second pattern on the surface of the second side have a same adjacent-pattern distance in a width direction, and/or a same adjacent-pattern distance in a length direction.

14. The through silicon via structure according to claim 12 or 13, wherein when there is one via, there are eight concave holes, and the eight concave holes are evenly distributed around the via.

15. The through silicon via structure according to claim 12 or 13, wherein there are a plurality of vias, and the plurality of vias comprise a first group of vias and a second group of vias; on the surface of the second side of the substrate layer, a first distance exists between any two adjacent vias in a first direction in the first group of vias, and a second distance exists between any two adjacent vias in the first direction in the second group of vias; and if the first distance is an integer multiple of the second distance, the concave hole is located between two adjacent vias in the first direction in the first group of vias, wherein the first direction is the length direction or the width direction.

16. The through silicon via structure according to any one of claims 12 to 15, wherein the concave hole on the surface of the second side of the substrate layer is in a circular, rectangular, or rhombus shape.

17. The through silicon via structure according to any one of claims 12 to 16, wherein a depth of the concave hole ranges from 1 micrometer to 30 micrometers.
